(19)

Europäisches
Patentamt
European
Patent Office
Office européen
des brevets

(11) **EP 2 763 281 A2**

(12) **EUROPEAN PATENT APPLICATION**
published in accordance with Art. 153(4) EPC

(43) Date of publication:
**06.08.2014 Bulletin 2014/32**

(21) Application number: **12837326.3**

(22) Date of filing: **25.09.2012**

(51) Int Cl.:
*H02J 17/00* (2006.01)          *B60L 11/18* (2006.01)
*H02J 7/00* (2006.01)

(86) International application number:
**PCT/KR2012/007723**

(87) International publication number:
**WO 2013/048092 (04.04.2013 Gazette 2013/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.09.2011   KR 20110097190**

(71) Applicant: **Korea Advanced Institute Of Science And Technology**
**Daejeon, Daejeon 305-701 (KR)**

(72) Inventors:
• **CHO, Dong-Ho**
  **Seoul 137-919 (KR)**
• **KIM, Joung-Ho**
  **Daejeon 305-701 (KR)**
• **CHUN, Yang-Bae**
  **Daejeon 305-761 (KR)**
• **KIM, Eun-Jung**
  **Daejeon 302-839 (KR)**

• **RYU, Ji-Yun**
  **Busan 611-821 (KR)**
• **KIM, Mi-Joo**
  **Muan-gun**
  **Jeollanam-do 534-873 (KR)**
• **HAN, Il-Song**
  **Daejeon 305-707 (KR)**
• **AHN, Seung-Young**
  **Seoul 137-767 (KR)**
• **KIM, Gyeng-Chul**
  **(3rd Fl.**
  **ICC Campus Jinrigwan**
  **Munji-dong)**
  **Yuseong-gu**
  **Daejeon 305-732 (KR)**
• **JEONG, Gu-Ho**
  **Daejeon 305-701 (KR)**

(74) Representative: **Nederlandsch Octrooibureau**
**P.O. Box 29720**
**2502 LS The Hague (NL)**

(54) **POWER SUPPLY AND PICKUP SYSTEM CAPABLE OF MAINTAINING STABILITY OF TRANSMISSION EFFICIENCY DESPITE CHANGES IN RESONANT FREQUENCY**

(57)    The present invention relates to a power supply and pickup system capable of maintaining stability of transmission efficiency despite changes in a resonant frequency. More particularly, the present invention relates to a power supply and pickup system capable of maintaining the stability of efficiency of transmitting power to a pickup device from a power supply device even when a voltage or current changes by the variation in a resonant frequency. According to the power supply and pickup system of the present invention, Q-factor of a power supply and pickup system is set to a low value, a stability of efficiency of transmitting power to a pickup device from a power supply device is maintained even when a voltage of current changes by the variation in a resonant frequency.

**FIG. 17**

| | | Qs | |
|---|---|---|---|
| | | 12.82 | 115 |
| Power transfer function @ 18kHz | | 0.858 | 0.870 |
| Power transfer function @ 20kHz | | 0.512 | 0.055 |

EP 2 763 281 A2

**Description**

Technical Field

The present invention relates to a power supply and pickup system that may maintain the stability of transmission efficiency despite a change in a resonant frequency, and more particularly, to a power supply and pickup system that may maintain the stability of efficiency of transmitting power from a power supply device to a pickup device even though a voltage or current varies due to a change in a resonant frequency.

Background Art

As for an existing wireless power transfer device, proposed is a device to achieve a maximum power transmission efficiency by accurately fixing a position of a power supply device and a position of a power pickup device and by increasing a Q-factor value for the optimal power transfer between the power supply device and the power pickup device. However, a resonant frequency of a system may vary based on a manufacturing process and may also vary due to an error of a part to be used. In particular, in a case of a wireless charging electric vehicle that is configured to be supplied with power from a power supply device while driving on the road in which the power supply device is laid, the power supply device is fixed whereas a position of a power pickup device may not be readily and accurately fixed. Also, at least two power pickup devices may be mounted to a vehicle to further collect power. In such a case, a resonant frequency of a system may vary and accordingly, the efficiency of transmitting power from a power supply device to a power pickup device may be significantly degraded.

Disclosure of Invention

Technical Goals

The present invention provides a power supply and pickup system that may maintain the stability of efficiency of transmitting power from a power supply device to a power pickup device even though a voltage or current varies due to a change in a resonant frequency by setting a Q factor of a power supply and pickup system to a relatively low value.

Technical Solutions

According to an aspect of the present invention, there is provided a power supply device for supplying power to a moving body using a magnetic induction method, the power supply device including: a power supply core including a magnetic pole to form a magnetic field in a predetermined direction; and a power supply coil disposed so that neighboring magnetic poles of the power supply core have different polarities, and in which a current flows. A Q factor by the power supply coil current is less than 100 and the Q factor is determined by $Q_S = \dfrac{w L_S}{R_S}$ Here, w denotes an angular frequency of the power supply coil current, $L_S$ denotes inductance of the power supply coil, and $R_S$ denotes resistance of the power supply coil.

According to another aspect of the present invention, there is provided a power supply device for supplying power to a moving body using a magnetic induction method, the power supply device including: a power supply core disposed to be in parallel with a heading direction of the moving body and including a plurality of magnetic poles disposed to be in parallel with each other; and a power supply coil extending along the heading direction of the moving body, and in which a current flows so that neighboring magnetic poles of the power supply core have different polarities on a surface perpendicular to the heading direction of the moving body. A Q factor by the power supply coil current is less than 100 and the Q factor is determined by $Q_S = \dfrac{w L_S}{R_S}$ Here, w denotes an angular frequency of the power supply coil current, $L_S$ denotes inductance of the power supply coil, and $R_S$ denotes resistance of the power supply coil.

A cross-section of the magnetic pole perpendicular to the heading direction of the moving body may have a "U" shape, and the power supply coil may be disposed within the U-shaped magnetic pole to be in parallel with the heading direction of the moving body.

A cross-section of the magnetic pole perpendicular to the heading direction of the moving body may have a shape in which two "U"s are horizontally adjacent to each other, and the power supply coil may be disposed to be in parallel with the heading direction of the moving body within each U-shaped magnetic pole.

The power supply core may be provided in a form in which power supply modules, disposed to be in parallel with the heading direction of the moving body and each including a plurality of magnetic poles in parallel with each other, are disposed in series.

According to still another aspect of the present invention, there is provided a power supply device for supplying power to a moving body using a magnetic induction method, the power supply device including: a power supply core including at least one magnetic pole disposed in series along a heading direction of the moving body; and power supply coils disposed to be in parallel with the heading direction of the moving body based on the left and the right of the magnetic pole and to intersect each other between the magnetic poles and in which a current flows so that neighboring magnetic poles of the power supply core have different polarities. A Q factor by the power supply coil current is less than 100 and the Q factor is determined by $Q_S = \dfrac{w L_S}{R_S}$ . Here, w denotes an angular frequency of the power supply coil current, $L_S$ denotes inductance of the power supply coil, and $R_S$ denotes resistance of the power supply coil.

A cross-section of the magnetic pole perpendicular to the heading direction of the moving body may be provided in a "T" shape, and the power supply coils may be disposed to be in parallel with the heading direction of the moving body on the left and right of each magnetic pole and to intersect each other between the magnetic poles. Currents towards opposite directions may flow in the power supply coils disposed on the left and the right of each magnetic pole.

The power supply device may further include a linear magnetic shielding member disposed in a heading direction of a road.

The power supply core may be provided in a form in which power supply modules, each including at least one magnetic pole disposed in series along the heading direction of the moving body, are disposed to constitute a column in series.

Each of the power supply modules may include core connecting members at a front end and a rear end, and power supply core modules may be connected to each other using the core connecting members and disposed to constitute a column in series along a heading direction of a road.

The power supply cores may be disposed to be separate from each other at predetermined intervals to be capable of accommodating a thermal expansion and a thermal shrinkage.

A fiber reinforced plastic (FRP) may be installed in an upper portion or a lower portion of the power supply core.

The power supply core may have a width perpendicular to the heading direction of the moving body less than or equal to a half of an interval between centers of the magnetic poles.

A length of the magnetic pole towards the heading direction of the moving body may be two folds or more of a distance between an end portion of the magnetic pole and an end portion of a magnetic pole adjacent thereto.

According to still another aspect of the present invention, there is provided a power pickup device to be supplied with power from a power supply device disposed along a heading direction of a moving body and installed in the moving body, the power pickup device including: a power pickup core disposed at a lower end of the moving body to be separate from the power supply device by a predetermined interval; and a power pickup coil disposed in the power pickup core in a loop form to flow an induction current induced from the power supply device. A Q factor by the power pickup coil current is less than 100 and the Q factor is determined by $Q_L = \dfrac{w L_L}{R_L}$ . Here, w denotes an angular frequency of the power pickup coil current, $L_L$ denotes inductance of the power pickup coil, and $R_L$ denotes resistance of the power pickup coil.

The power pickup core may be provided in a form of a plate or a lattice.

The power pickup device may further include a magnetic shielding member provided in a loop shape around the power pickup core.

## Effects of the Invention

According to embodiments of the present invention, there may be provided a power supply and pickup system that may maintain the stability of efficiency of transmitting power from a power supply device to a power pickup device even though a voltage or current varies due to a change in a resonant frequency by setting a Q factor of a power supply and pickup system to a relatively low value.

## Brief Description of Drawings

FIG. 1 is a diagram illustrating a configuration of a wireless power transfer system in an electric vehicle.
FIG. 2 is a perspective view of a power supply device and a power pickup device.
FIG. 3 is a cross-sectional view of a power supply device and a power pickup device viewed from the front.
FIG. 4 is a view illustrating a structure of a cross-section of a power pickup device applied to an electric vehicle.
FIG. 5 is a magnetic field distribution map in a state in which a shaped magnetic field in resonance (SMFIR) technology is not applied.
FIG. 6 is a magnetic field distribution map in a state in which an SMFIR technology is applied.
FIG. 7 illustrates a magnetic field distribution map expressed as a magnetic flux density vector after applying an SMFIR technology.
FIG. 8 illustrates an equivalent circuit of a wireless power transfer system having a power source with power of a power supply device.
FIG. 9 illustrates an equivalent circuit of a wireless power transfer system having a voltage source with power of a power supply device.
FIG. 10 illustrates a structure of an I-shaped power supply device.
FIG. 11 illustrates an embodiment in which a power pickup core of a power pickup device is provided in a form of a lattice.
FIG. 12 illustrates a power supply module modulated in a size corresponding to an interval between magnetic poles to easily install a power supply device on a bent road.
FIG. 13 illustrates an embodiment of a structure for coping with expansion and shrinkage that occurs due to a change of a power supply device in temperature.
FIG. 14 illustrates a structure of a W-shaped power supply device.
FIG. 15 is a view describing a magnetic shielding method of an I-shaped power supply device and a power pickup device.
FIG. 16 is a graph and a table showing a transmission efficiency according to a Q factor ($Q_s$) of a power supply device in a case in which a resonant frequency of a power supply and pickup system is 20 kHz and a current signal of 20 kHz is applied as an operating frequency.
FIG. 17 is a graph and a table showing a transmission efficiency according to a Q factor ($Q_s$) of a power supply device in a case in which a resonant frequency of a power supply and pickup system is 18 kHz and a current signal of 20 kHz is applied as an operating frequency.
FIG. 18 is a graph and a table showing a transmission efficiency according to a Q factor ($Q_L$) of a power pickup device in a case in which a resonant frequency of a power supply and pickup system is 20 kHz and a current signal of 20 kHz is applied as an operating frequency.
FIG. 19 is a graph and a table showing a transmission efficiency according to a Q factor ($Q_L$) of a power pickup device in a case in which a resonant frequency of a power supply and pickup system is 18 kHz and a current signal of 20 kHz is applied as an operating frequency.

## Best Mode for Carrying Out the Invention

Hereinafter, exemplary embodiments of the present invention will be described with reference to the accompanying drawings. Prior to describing the present invention, terms or words used in the present specification and the claims should not be limited and thereby interpreted as general or lexical meanings and should be interpreted as meanings and concepts that fit the technical spirit of the present invention on the basis of the principle that the inventor may appropriately define the concepts of terms to describe the inventor's invention using the best mode. Accordingly, embodiments disclosed in the present specification and configurations illustrated in the drawings are only examples of the present invention and do not represent all the technical spirit of the present invention and thus, it should be understood that various equivalents and modification examples capable of replacing them may be present at an application point in time of the present application.

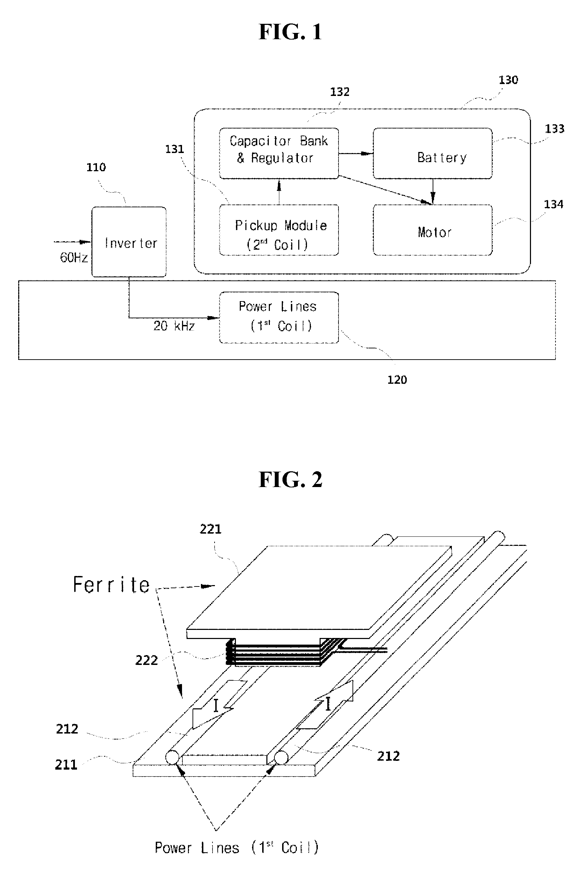

FIG. 1 is a diagram illustrating a configuration of a wireless power transfer system in an electric vehicle.

Power, for example, 60 Hz produced at a power company is applied to an inverter 110 and the inverter 110 generates a current of a wireless power transfer frequency, for example, 20 kHz. The generated current flows through a power supply coil 120 of a power supply device whereby an electric field is formed. A portion of the electric field generates power due to a power pickup coil within a power pickup device 131. The generated power is used to charge a battery 133 through a regulator 132 and to drive a motor 134.

More specifically describing, the inverter 110 configured to supply power functions to generate a signal of a wireless power transfer frequency band. The power supply coil 120 that is a power supply device for wirelessly transmitting power serves as a kind of a transmission antenna. A shaped magnetic field in resonance (SMFIR) technology for determining a shape of a magnetic field through a metal or a nonmetal magnetic body such as ferrite is required. A key element of the power pickup device 131 that is a transmission end configured to receive power is a power pickup coil. Using the power pickup coil alone, a path of a magnetic field may not be readily formed in a desired shape in the power pickup device. Accordingly, similar to the power supply device, an SMFIR technology by a power pickup core using a metal or a nonmetal magnetic body is applied. In a case of an electric vehicle, load includes thee motor 134 or the battery 133 and consumes the produced power.

FIG. 2 is a perspective view of a power supply device and a power pickup device.

When current flows in a power supply coil 212 above a power supply core 211 laid underground, a magnetic field is formed. When the formed magnetic field passes through a power pickup coil 222 wound around a power pickup core 221 of a power pickup device, voltage, for example, induced electromotive power is induced at both ends of the power pickup coil 222. Accordingly, when resistive load such as a battery and a motor is connected at both ends of the power pickup device, the power is consumed at the load.

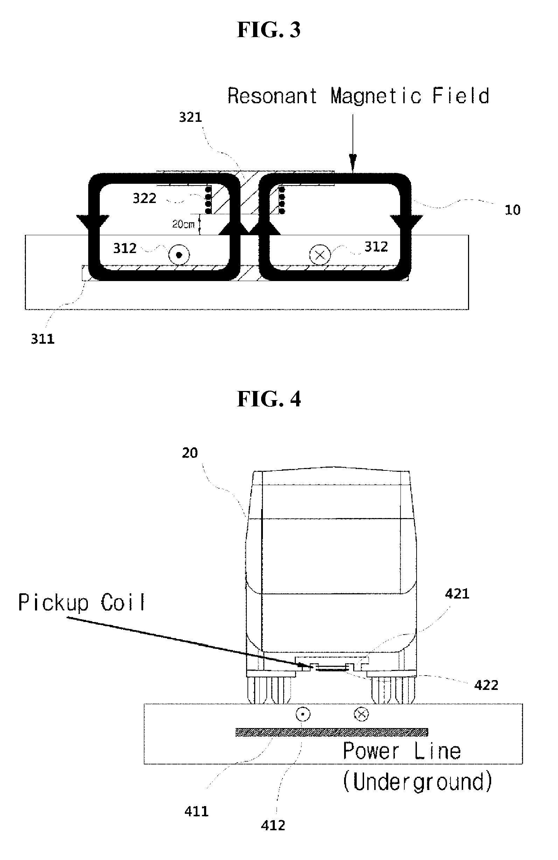

FIG. 3 is a cross-sectional view of a power supply device and a power pickup device viewed from the front.

In a case in which a power supply core 311 of the power supply device is provided in a form of a plate, as illustrated in FIG. 3, in which a direction of a magnetic field cannot be easily concentrated in a constant direction, a magnetic field occurring in a power supply coil 312 laid underground passes through a power pickup coil 322 and forms a large loop overall as indicated by an arrow indicator 10. In this case, a power transfer capability concentrated at the power pickup device is deteriorated. The power supply core 311 and a power pickup core 321 to adjust a transfer direction of a magnetic field may use ferrite. Adjusting the shape of the magnetic field using a magnetic body, ferrite, is an essential element for an SMFIR technology.

FIG. 4 is a view illustrating a structure of a cross-section of a power pickup core 421 and a power pickup coil 422 applied to an electric vehicle 20.

A power supply core 411 and a power supply coil 412 provided in a form of a plate are laid under the road, that is, underground.

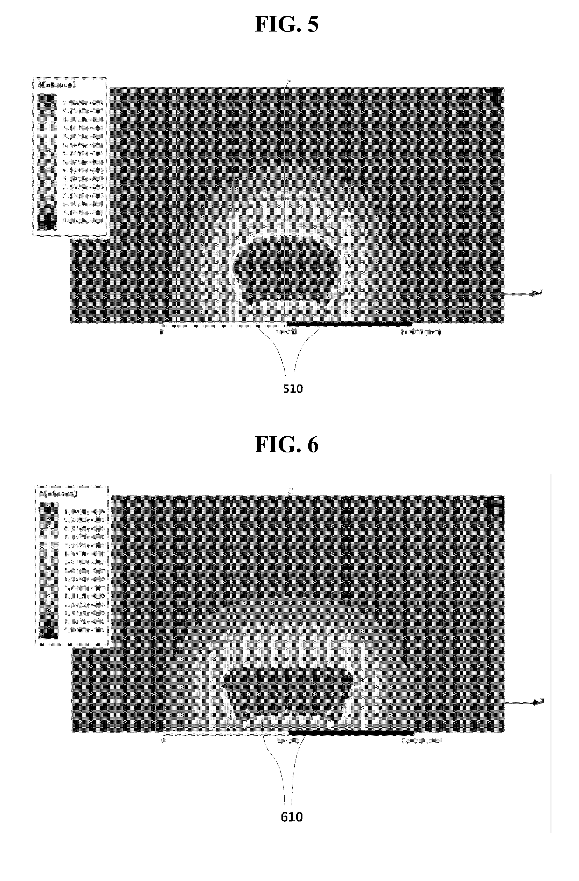

FIG. 5 is a magnetic field distribution map in a state in which an SMFIR technology is not applied.

In a case in which the SMFIR technology is not applied, a magnetic field is formed 360-degree omni-directionally based on a power supply coil 510 in which current flows, and the entire magnetic field includes a sum of magnetic fields formed by the respective power lines. Each of a power supply device, for example, a transmission coil and a power pickup device, for example, a reception coil may show a magnetic field distribution in an overall round shape. A magnetic field distribution may be formed in a shape in which two circles are disposed to be close overall.

FIG. 6 is a magnetic field distribution map in a state in which an SMFIR technology is applied.

When the SMFIR technology using a magnetic body is applied, a magnetic field may be easily formed in a place in which the magnetic body is present and may not be easily formed in a place in which the magnetic body is absent instead of being radiated 360-degree omni-directionally. As illustrated in FIG. 6, due to the presence of the magnetic body at a corresponding position, the magnetic field is evenly formed along a predetermined shape at a partial location 610. Such technology serves to improve a transfer capacity and efficiency of power by forming the magnetic field and thereby generating a transfer path of power. Also, in a case of installing a power pickup device in a limited space, for example, a limited height, such as a case of installing the power pickup device in a lower portion of a vehicle, it is possible to prevent the magnetic field from extending omni-directionally and thereby affecting another device or material. Accordingly, it is possible to prevent a heat from being generated due to eddy current that occurs due to a leakage magnetic field. Also, the technology may be used as a fundamental countermeasure for minimizing an effect of a magnetic field against a human body.

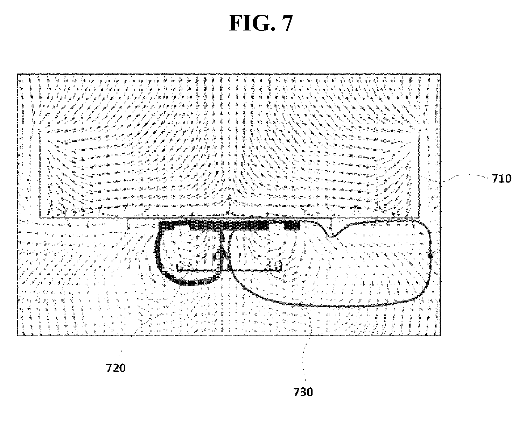

FIG. 7 illustrates a magnetic field distribution map expressed as a magnetic flux density vector after applying an SMFIR technology.

Once the SMFIR technology is applied, a magnetic field is formed along a shaped path instead of widely extending omni-directionally. In FIG. 7, the distribution of a magnetic field formed after applying the SMFIR technology to a power supply device and a power pickup device is illustrated using a vector. An upwardly U-shaped structure 710 refers to a metal plate that is a car body of a vehicle. In a case of installing the power pickup device in a lower portion of the vehicle, it is possible to prevent the magnetic field from being directly incident to the vehicle by applying the SMFIR technology. When the magnetic field is vertically incident to a metal plate, the heat is generated due to eddy current. In a system using huge power such as a vehicle, the generated heat may become a great constraint. When the SMFIR technology is applied, it is possible to shape the magnetic field not to be incident to the metal plate.

A bold arrow indicator 720 on the left between arrow indicators drawing a loop shape represents a path of a magnetic field transferred from the power supply device to the power pickup device. In a case of generating a path of a magnetic field in a shape desired by a designer using the SMFIR technology as described above, the power pickup capacity and the power pickup efficiency may be enhanced. Also, a leakage magnetic field appearing to be large as indicated by a thin arrow indicator 730 on the right may be decreased. Accordingly, an effect of the magnetic field against a human body may also be fundamentally decreased.

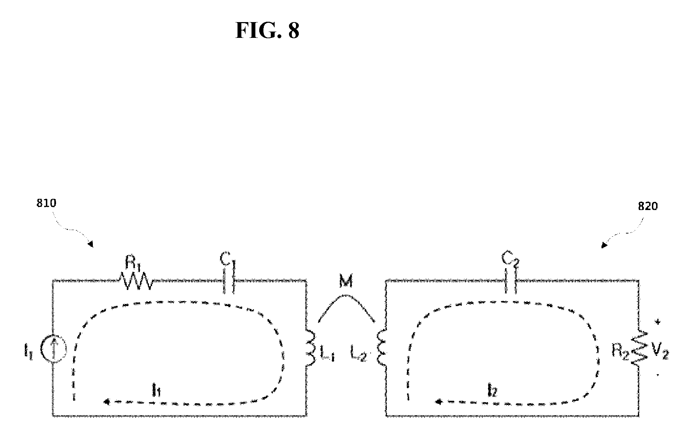

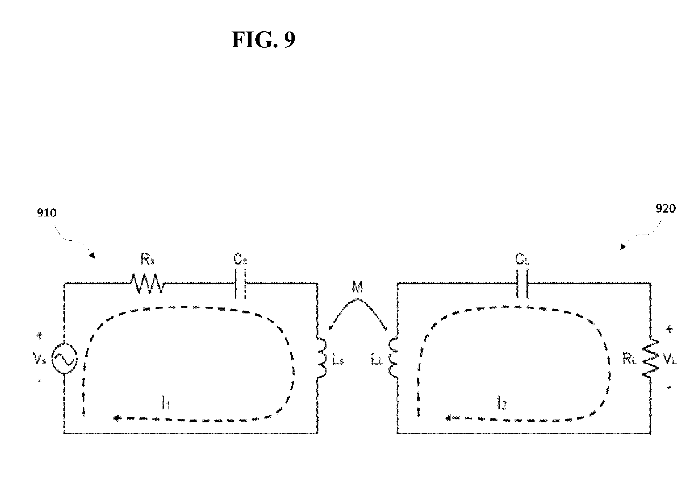

FIG. 8 illustrates an equivalent circuit of a wireless power transfer system having a power source with power of a power supply device, and FIG. 9 illustrates an equivalent circuit of a wireless power transfer system having a voltage source with power of a power supply device.

Hereinafter, an equation of calculating a power transfer function will be induced with reference to FIG. 9.

A left circuit 910 refers to an equivalent circuit of a power supply device and a right circuit 920 refers to an equivalent circuit of a power pickup device. A Q factor of the equivalent circuit of the power supply device is $Q_S$ and a Q factor of the equivalent circuit of the power supply device is $Q_L$.

Equation 1 is obtained from the left circuit 910 corresponding to the equivalent circuit of the power supply device and Equation 2 is obtained from the right circuit 920 corresponding to the equivalent circuit of the power pickup device.

[Equation 1]

$$\left( R_S + \frac{1}{jw\,C_S} + jw\,L_S \right) I_1 - jwM I_2 - V_S = 0$$

[Equation 2]

$$\left( R_L + \frac{1}{jw\,C_L} + jw\,L_L \right) I_2 - jwM I_1 = 0$$

Equation 3 is obtained from Equation 2.

[Equation 3]

$$I_1 = \frac{R_L + \frac{1}{jw\,C_L} + jw\,L_L}{jwM} I_2$$

Equation 4 is obtained by substituting Equation 3 for Equation 1.

[Equation 4]

$$I_2 = \frac{jwM}{(R_S + \frac{1}{jwC_S} + jwL_S) \times (R_L + \frac{1}{jwC_L} + jwL_L) + w^2M^2} V_S$$

Power of the equivalent circuit of the power pickup device indicated as the right circuit 920 is expressed by $P_L = I_2^2 \times R_L$ When substituting Equation 4 for this equation, Equation 5 is obtained.

[Equation 5]

$$P_L = \left| \frac{-w^2M^2}{\left[ (R_S + \frac{1}{jwC_S} + jwL_S) \times (R_L + \frac{1}{jwC_L} + jwL_L) + w^2M^2 \right]^2} \right| V_S^2 R_L$$

Also, power of the equivalent circuit of the power supply device indicated as the left circuit 910 is expressed by $P_S = I_1 \times V_S$. When substituting Equation 3 and Equation 4 for this equation, Equation 6 is obtained.

[Equation 6]

$$P_S = \frac{R_L + \frac{1}{jwC_L} + jwL_L}{(R_S + \frac{1}{jwC_S} + jwL_S) \times (R_L + \frac{1}{jwC_L} + jwL_L) + w^2M^2} V_S^2$$

Equation 7 that expresses a power transfer function K indicating the efficiency of wirelessly transmitting power from the power supply device to the power pickup device is induced from Equation 5 and Equation 6.

[Equation 7]

$$K = \frac{P_L}{P_S} = \frac{w^2M^2R_L}{\left[ (R_S + \frac{1}{jwC_S} + jwL_S) \times (R_L + \frac{1}{jwC_L} + jwL_L) + w^2M^2 \right](R_L + \frac{1}{jwC_L} + jwL_L)}$$

$$K = \frac{w^2M^2R_L}{\left[ (R_S + \frac{1}{jwC_S} + jwL_S) \times (R_L + \frac{1}{jwC_L} + jwL_L) + w^2M^2 \right](R_L + \frac{1}{jwC_L} + jwL_L)}$$

$$= \frac{1}{\left[ (\frac{R_S}{wM} + \frac{jwL_S}{wM}(1 - \frac{1}{w^2L_SC_S})) \times (\frac{R_L}{wM} + \frac{jwL_L}{wM}(1 - \frac{1}{w^2L_LC_L})) + 1 \right]\left(1 + \frac{1}{jwR_LC_L} + jw\frac{L_L}{R_L}\right)}$$

is induced from Equation 7.
Here, when applying, to the induced equation,

$$Q_{MS} = \frac{wM}{R_S}, \quad Q_{ML} = \frac{wM}{R_L}, \quad Q_S = \frac{wL_S}{R_S}, \quad Q_L = \frac{wL_L}{R_L}$$ and resonant frequencies $$w_{OS} = \frac{1}{\sqrt{L_S C_S}}, \quad w_{OL} = \frac{1}{\sqrt{L_L C_L}}$$ of the equivalent circuit of the power supply device and the equivalent circuit of the power pickup device, Equation 8 is obtained.

[Equation 8]

$$K = \cfrac{1}{\left[\cfrac{1}{Q_{MS} Q_{ML}} \times \left(1 + j Q_S \times (1 - \frac{w^2_{OS}}{w^2})\right) \times \left(1 + j Q_L \times (1 - \frac{w^2_{OL}}{w^2})\right) + 1\right]\left(1 + j Q_L \times (1 - \frac{w^2_{OL}}{w^2})\right)}$$

Also, $$M = k\sqrt{L_S L_L}$$ may be established. Here, k denotes a coupling coefficient representing a correlation between $L_S$ and $L_L$. From this,

$$Q_{MS} \cdot Q_{ML} = \frac{wM}{R_S} \cdot \frac{wM}{R_L} = \frac{w^2 M^2}{R_S R_L} = \frac{w^2 k^2 L_S L_L}{R_S R_L} = k^2 \frac{wL_S}{R_S} \frac{wL_L}{R_L}$$ may be established. When substituting the same for Equation 8, Equation 9 may be established.

[Equation 9]

$$K = \cfrac{1}{\left[\cfrac{1}{k^2 Q_S Q_L} \times \left(1 + j Q_S \times (1 - \frac{w^2_{OS}}{w^2})\right) \times \left(1 + j Q_L \times (1 - \frac{w^2_{OL}}{w^2})\right) + 1\right]\left(1 + j Q_L \times (1 - \frac{w^2_{OL}}{w^2})\right)}$$

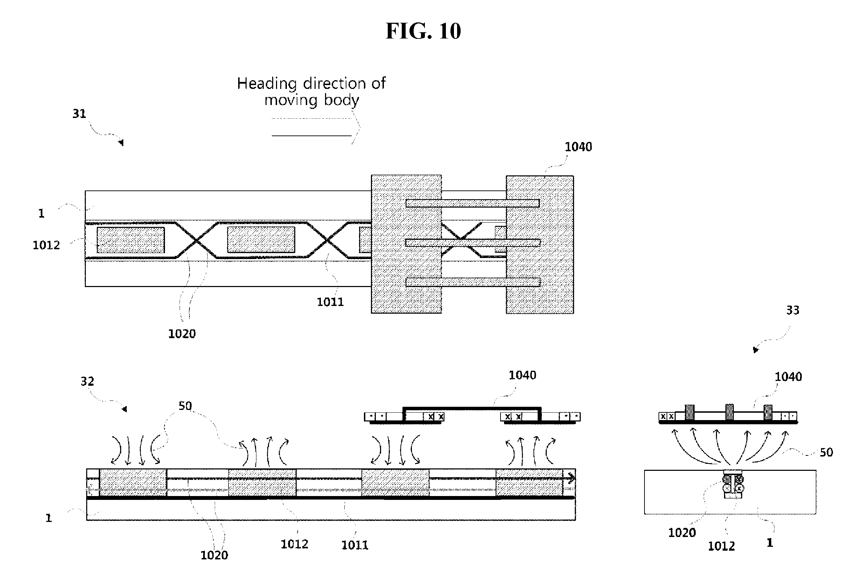

FIG. 10 illustrates a structure of an I-shaped power supply device.

A power supply device may supply power to a moving body using a magnetic induction method and a power pickup device may be attached to the moving body to collect power from the power supply device using a magnetic induction method and to charge a battery. FIG. 10 illustrates a top view 31, a side view 32, and a front view 33 of the I-shaped power supply device and the power pickup device to collect the power from the I-shaped power supply device in a cross-sectional form.

FIG. 10 illustrates a case in which the power supply device is laid under a road 1 as an embodiment of the I-shaped power supply device.

The I-shaped power supply device includes a power supply core 1011 including a plurality of magnetic poles 1012 disposed in series along a heading direction of the moving body and a power line 1020 disposed so that neighboring magnetic poles 1012 of the power supply core 1011 may have different polarities, that is, so that N pole and S pole may alternately occur. In the embodiment of FIG. 10, currents towards opposite directions flow in the power lines 1020. Accordingly, as illustrated in the side view 32, magnetic fields 50 towards opposite directions may be formed above the continuous magnetic poles 1012 and thus, the N pole and the S pole may alternately occur. In such a manner, the power may be supplied to the moving body traveling above using a magnetic induction method. A power pickup device 1040 may collect the power from the power supply device. Calling "I shape" is because a cross-section of the magnetic pole 1012 is provided in an "I" shape as illustrated in the front view 33. However, other shapes slightly modified and enhanced from the "I" shape may be sufficiently possible, which may also be referred to as the "I shape".

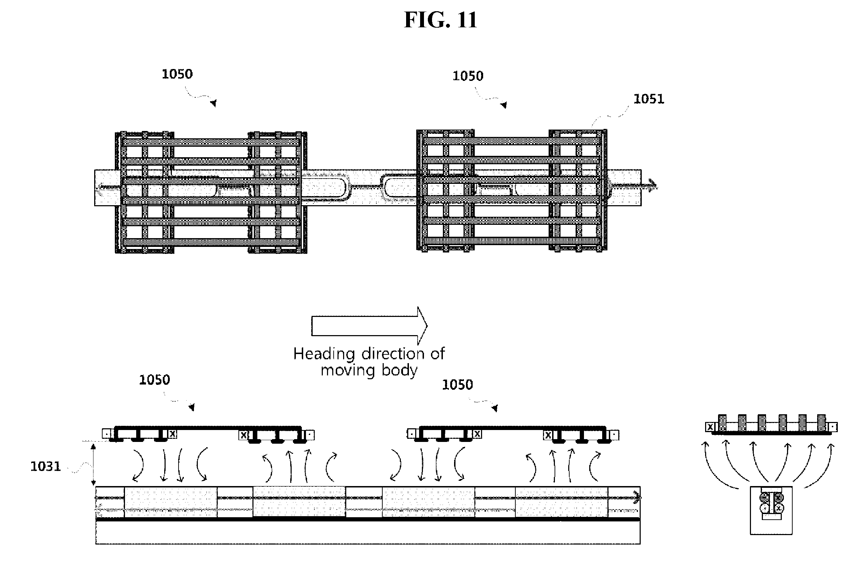

As illustrated in FIG. 10, a power supply core may have a width perpendicular to a heading direction of a moving body less than or equal to a half of an interval between centers of magnetic poles 1012. As described above, by providing a magnetic pole 1012 in an I shape, it is possible to significantly decrease the width of the magnetic pole 1012 and to alternately generate the N pole and the S pole in a heading direction of a road. Accordingly, it is possible to significantly decrease an electromagnetic field (EMF) on the left and the right of a power line, and to reduce installation cost of the power line. Further, a distance between a power supply device laid underground and a power pickup device 1040 installed in a lower portion of a vehicle, that is, a gap interval 1031 of FIG. 11 may be maintained to be greater than or equal to a predetermined interval and power may be appropriately supplied. Also, due to a narrow width of a power line using a narrow I-shaped magnetic pole, it is possible to reduce left and right widths of the power pickup device 1040 installed in the vehicle. When the power pickup device 1040 has at least predetermined left and right widths within the above range, it is possible to increase left and right tolerance deviations compared to a power line in a different structure. Accordingly, a wide left and right tolerance characteristic compared to the different structure may be achieved.

Also, as illustrated in FIG. 10, a length of the magnetic pole 1012 towards the heading direction of the moving body may be two folds or more of a distance between an end portion of the magnetic pole and an end portion of a magnetic pole adjacent thereto.

A power supply core 1011 may be provided in a form in which power supply modules, each including at least one magnetic pole 1012 disposed in series along the heading direction of the moving body, are disposed to constitute a column in series. That is, a power supply core 1011 including a magnetic pole 1012 may be modulated and the respective modules may be connected in series.

FIG. 11 illustrates an embodiment in which a power pickup core 1051 of a power pickup device 1050 is provided in a form of a lattice.

The above structure may reduce a weight of the power pickup core 1051 and may be advantageous in cooling and readily manufacturing the power pickup core 1051 in a mechanical solid structure. If an interval between bars is less than or equal to a half of the gap interval 1031 that is sufficiently small, no great affect may be applied to electrical performance.

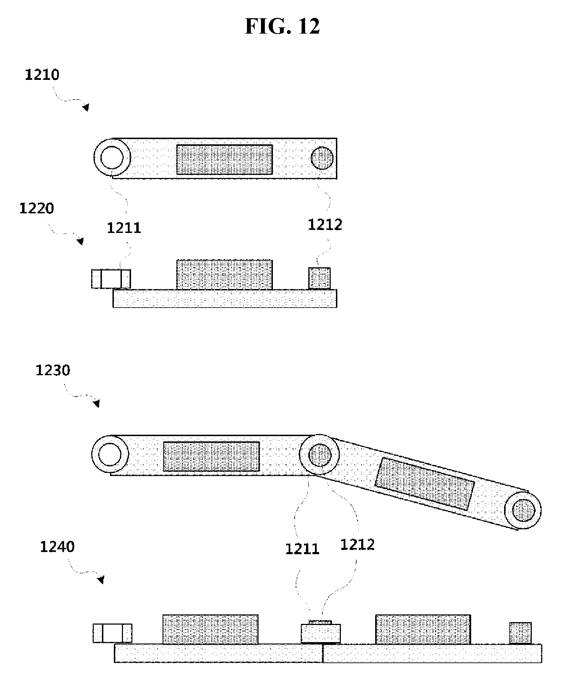

FIG. 12 illustrates a power supply module modulated in a size corresponding to an interval between magnetic poles to easily install a power supply device on a bent road.

A top view 1210 and a side view 1220 of each power supply core module are illustrated. Core connecting members 1211 and 1212 in a male and female structure having a wide contact area in a magnetic circuit perspective and simply combinable in a mechanical perspective are provided on both ends of each power supply core module. Through the above configuration, an angle may need to be twisted only slightly along the roads bent in a horizontal direction while coupling power supply core modules on the field. A top view 1230 and a side view 1240 illustrate a form in which the power supply core modules are connected using the core connecting members 1211 and 1212. Also, although not illustrated, a core module applicable even to the vertically bent roads such as an inclined plane may be configured using the same principle.

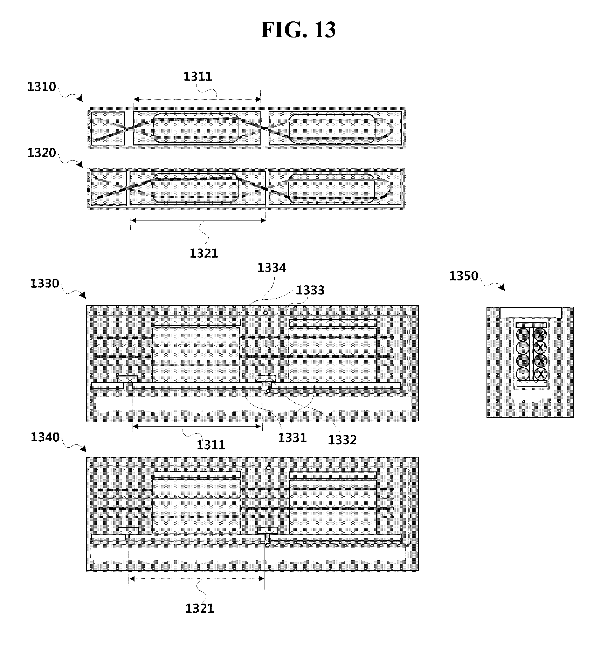

FIG. 13 illustrates an embodiment of a structure for coping with expansion and shrinkage that occurs due to a change of a power supply device in temperature.

FIG. 13 illustrates a top view 1310, a side view 1330, and a length 1311 of a power supply core in a case in which the power supply device is thermally shrunk. Also, FIG. 13 illustrates a top view 1320, a side view 1340, and a length 1321 of a power supply core, and a front view 1350 in a case in which the power supply device is thermally expanded.

A road needs to tolerate a change of about -20 degrees to +80 degrees. Aspects that a magnetic material or a cable constituting the power supply device, a cable protecting mechanical such as a fiber reinforced plastic (FRP) or a PVC pipe, and asphalt or cement are thermally expanded and thermal expansion coefficients are different need to be considered. Also, during the above process, a waterproof characteristic may need to be maintained in a good condition.

Accordingly, the respective structures are discrete at predetermined inetrvals along the heading direction of the road and maintaining the connecting surface between the structures to be waterproof becomes an issue. FIG. 13 illustrates an example in which a core connecting member 1332 made of the same magnetic material is provided between power supply cores 1331 in the heading direction of the roads. Also, FIG. 13 illustrates a case in which an FRP 1333 is disconnected and thereby coupled and a coupling portion thereof is processed using an O-ring 1334. A shrinkage tube or a bond coupling may be used for coupling an FRP or a polyvinyl chloride (PVC) pipe. Also, there is no need to connect the FRP or the PVC pipe each time using an elastic connecting member. The elastic connecting member may be used every one time per a few meters to tens of meters. Here, a general cable is flexible and thus, may not require the aforementioned countermeasure separately.

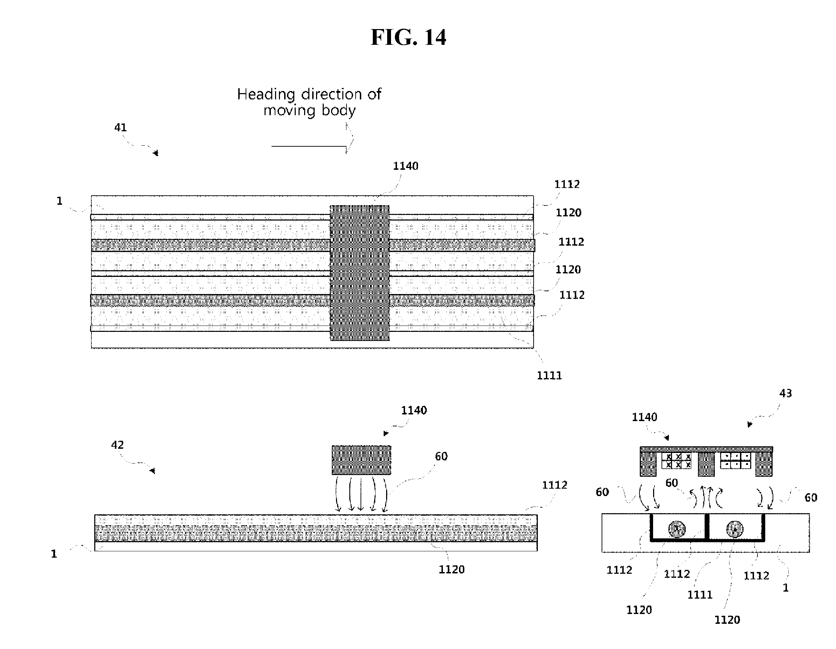

FIG. 14 illustrates a structure of a W-shaped power supply device.

FIG. 14 illustrates a top view 41, a side view 42, and a front view 43 of the W-shaped power supply device and a power pickup device to collect power from the W-shaped power supply device.

FIG. 14 illustrates a case in which the W-shaped power supply device is laid under a road as an embodiment of the W-shaped power supply device.

The W-shaped power supply device includes a power supply core 1111 disposed to be in parallel with a heading direction of a moving body and including a plurality of magnetic poles 1112 disposed to be in parallel with each other, and a power line 1120 extending along the heading direction of the moving body so that neighboring magnetic poles of the power supply core may have different polarities on a surface perpendicular to the heading direction of the moving body, that is, so that N pole and S pole may alternately occur. In a case of the embodiment of FIG. 14, as illustrated in the front view 43, currents towards opposite directions flow in the two power lines 1120. Also, as illustrated in the front view 43, magnetic fields 60 towards opposite directions may be formed above the magnetic poles 1112 in parallel with the heading direction of the moving body and extending in parallel with each other and thus, the N pole and the S pole may alternately occur. In such a manner, the power may be supplied to the moving body traveling above using a magnetic induction method and a power pickup device 1140 may collect the power. Calling "W shape" is because a cross-section of the power supply core 1111 including the magnetic pole 1112 is provided in a "W" shape as illustrated in the front view 43. However, other shapes slightly modified and enhanced from the "W" shape may be sufficiently possible, which may also be referred to as the "W" shape. For example, referring to the front view 43, no magnetic pole stands in the middle and thus, only two magnetic poles stand in parallel with each other at both sides and thus, only a single pair of N pole and S pole may be present. In this example, although the corresponding shape may be close to a "U" shape, it will be generally referred to as a W shape. The W-shaped power supply device may be provided in a form in which power supply cores of a U-shaped power supply device are disposed to be adjacent to each other in parallel with the heading direction of the moving body.

A power supply core may be provided in a form in which power modules, disposed to be in parallel with the heading direction of the moving body and each including a plurality of magnetic poles in parallel with each other, are disposed in series along the heading direction of the moving body. That is, a power supply core including a magnetic pole may be modulated and the respective modules may be connected in series.

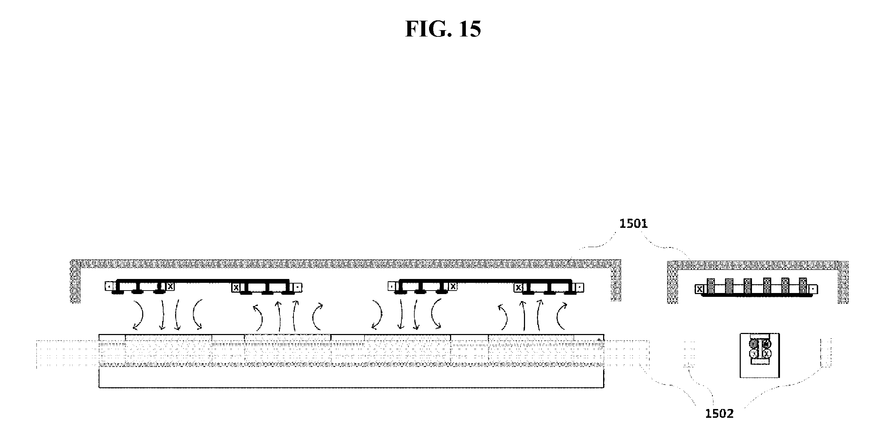

FIG. 15 is a view describing a magnetic shielding method of an I-shaped power supply device and a power pickup device.

An I-shaped power pickup device may have a size that is reduced by about a half of a car width and thus, may have a spatial room for magnetic shielding. Accordingly, when a looped magnetic shielding material 1501 surrounds around the I-shaped power supply device, leakage magnetic flux is magnetically grounded along the magnetic shielding loop 1501 and thus, a magnetic shielding effect may be achieved. Magnetic shielding may be achieved only along the side surface and may be achieved by covering a top surface.

In a case of the I-shaped power supply device, magnetic poles may alternately change at predetermined intervals and an electromagnetic field (EMF) may be formed in a lateral direction. Accordingly, when an I-shaped magnetic shielding line 1502 is provided in a lengthwise direction, magnetic ground may be performed in the lengthwise direction and a magnetic shielding effect may be achieved.

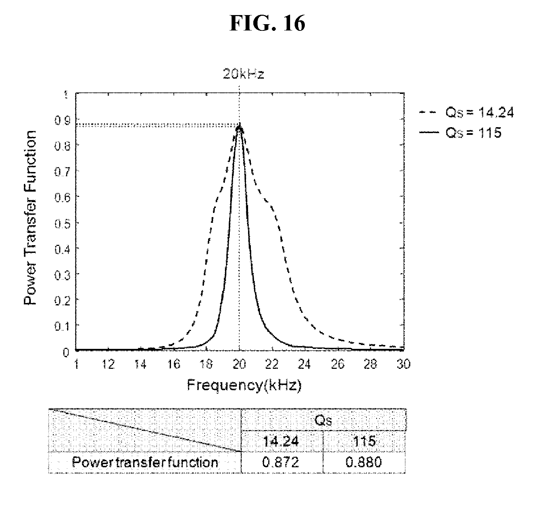

FIG. 16 is a graph and a table showing a transmission efficiency according to a Q factor (Qs) of a power supply device in a case in which a resonant frequency of a power supply and pickup system is 20 kHz and a current signal of 20 kHz is applied as an operating frequency.

A resonant frequency of the system may vary based on a manufacturing process and may also vary based on an error of a part being used. In particular, in a case in which a power supply device is fixed and a power pickup device is mobile such as a wireless charging electric vehicle, or in a case in which a single power supply device is present and an additional power pickup device further collects power, the resonant frequency of the system may vary.

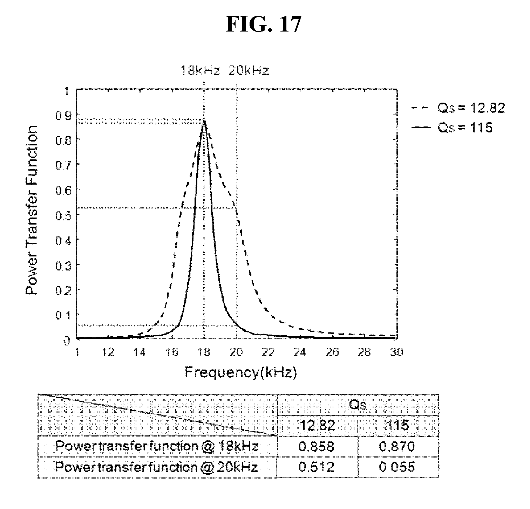

FIG. 16 illustrates a case in which a resonant frequency and an operating frequency match at 20 kHz. It can be known from FIG. 16 that in a case in which $Q_S$ is greater than 100 ($Q_S$ = 115), a power transmission efficiency at the operating frequency is slightly enhanced compared to a case in which $Q_S$ is less than 100 (Qs = 14.24) (0.872 --> 0.880, see the table disposed at the bottom of FIG. 16). However, if the operating frequency and the resonant frequency differ, a case in which $Q_S$ is less than 100 is further advantageous in an aspect of a power transfer sensitivity compared to a case in which $Q_S$ is greater than 100, which is illustrated in FIG. 17 and will be described below.

FIG. 17 is a graph and a table showing a transmission efficiency according to a Q factor (Qs) of a power supply device in a case in which a resonant frequency of a power supply and pickup system is 18 kHz and a current signal of 20 kHz is applied as an operating frequency.

As described above with reference to FIG. 16, in a case in which a resonant frequency of a power supply and pickup system matches an operating frequency of an applied signal, it may not greatly affect the Q factor and a high power transfer function may be maintained. However, in a case in which the Q factor is relatively great, a width of a frequency band becomes narrow and thus, a transmission efficiency may significantly vary based on the operating frequency.

Referring to FIG. 17, if the resonant frequency is deviated from the operating frequency, a case in which $Q_S$ is less than 100 ($Q_S$ = 12.82) shows a further enhanced transmission efficiency at the corresponding operating frequency of 20 kHz compared to a case in which $Q_S$ is greater than 100 ($Q_S$ = 115) (0.055 --> 0.512, see the table disposed at the bottom of FIG. 17). As described above, if the resonant frequency of 18 kHz is deviated from the operating frequency of 20 kHz and thereby shakes, a case in which Qs is less than 100 (Qs = 12.82) is less sensitive to a change in the transmission efficiency of the wireless power transfer system compared to a case in which Qs is greater than 100 (Qs = 115) and thus, may achieve a further enhanced stability.

As described above, in a case in which a power supply device is fixed and a power pickup device is mobile and thus, power supply and pickup locations are easy to be twisted such as a wireless charging electric vehicle, or in a case in which a single power supply device is present and an additional power pickup device further collects power, it may be desirable to use a Q factor value of the power supply device to be less than or equal to 100 for the efficiency and stability of power transfer. Also, in a case of a large power system such as power supply and pickup for vehicle, an internal pressure at which a part is tolerable is also a very important element. Accordingly, in the present invention, to achieve the above purpose, it may be desirable to use a Q factor value of the power supply device to be less than or equal to 100.

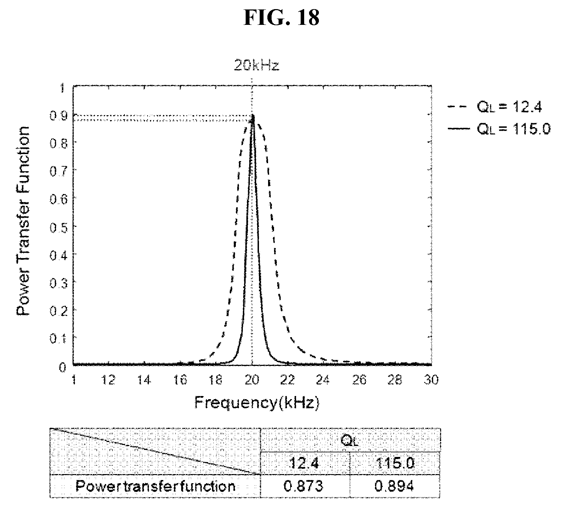

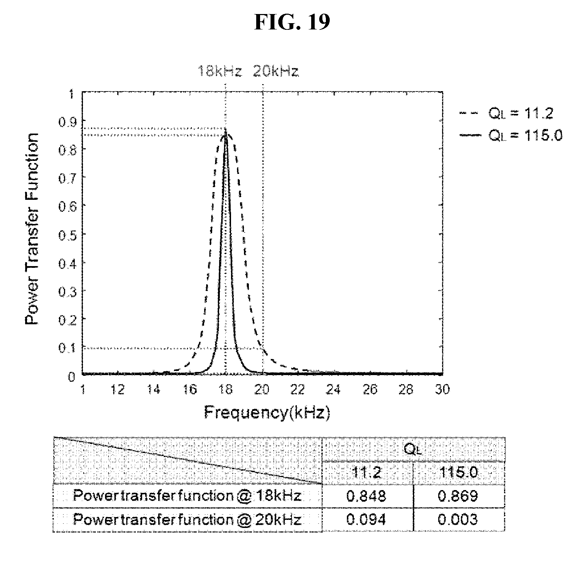

FIG. 18 is a graph and a table showing a transmission efficiency according to a Q factor ($Q_L$) of a power pickup device in a case in which a resonant frequency of a power supply and pickup system is 20 kHz and a current signal of 20 kHz is applied as an operating frequency. FIG. 18 illustrates a case in which a resonant frequency and an operating frequency match at 20 kHz. It can be known from FIG. 18 that in a case in which $Q_L$ is greater than 100 ($Q_L$ = 115), a power transmission efficiency at the operating frequency is slightly enhanced compared to a case in which $Q_L$ is less than 100 ($Q_L$ = 12.4) (0.873 --> 0.894, see the table disposed at the bottom of FIG. 18). However, if the operating frequency and the resonant frequency differ, a case in which $Q_L$ is less than 100 is further advantageous in an aspect of a power transfer sensitivity compared to a case in which $Q_L$ is greater than 100, which is illustrated in FIG. 19 and will be described below.

FIG. 19 is a graph and a table showing a transmission efficiency according to a Q factor ($Q_L$) of a power pickup device in a case in which a resonant frequency of a power supply and pickup system is 18 kHz and a current signal of 20 kHz is applied as an operating frequency. As described above, if the resonant frequency of 18 kHz is deviated from the operating frequency of 20 KHz, a case in which $Q_L$ is less than 100 ($Q_L$ = 11.2) shows a further enhanced transmission efficiency at the corresponding operating frequency of 20 kHz compared to a case in which $Q_L$ is greater than 100(QL = 115) (0.003 --> 0.094, see the table disposed at the bottom of FIG. 19). As described above, if the resonant frequency is deviated from the operating frequency of 20 kHz and thereby shakes, a case in which $Q_L$ is less than 100 ($Q_L$ = 11.2) is less 1sensitive to a change in the transmission efficiency of the wireless power transfer system compared to a case in which $Q_L$ is greater than 100 ($Q_L$ = 115) and thus, may achieve a further enhanced stability.

Although a few embodiments of the present invention have been shown and described, the present invention is not limited to the described embodiments. Instead, it would be appreciated by those skilled in the art that changes may be made to these embodiments without departing from the principles and spirit of the invention, the scope of which is defined by the claims and their equivalents.

**Claims**

1. A power supply device for supplying power to a moving body using a magnetic induction method, the power supply device comprising:

   a power supply core comprising a magnetic pole to form a magnetic field in a predetermined direction; and
   a power supply coil disposed so that neighboring magnetic poles of the power supply core have different polarities, and in which a current flows,
   wherein a Q factor by the power supply coil current is less than 100 and the Q

   factor is determined by $$Q_S = \frac{w L_S}{R_S},$$

   where w denotes an angular frequency of the power supply coil current, $L_S$ denotes inductance of the power supply coil, and $R_S$ denotes resistance of the power supply coil.

2. A power supply device for supplying power to a moving body using a magnetic induction method, the power supply device comprising:

   a power supply core disposed to be in parallel with a heading direction of the moving body and comprising a plurality of magnetic poles disposed to be in parallel with each other; and
   a power supply coil extending along the heading direction of the moving body, and in which a current flows so that neighboring magnetic poles of the power supply core have different polarities on a surface perpendicular to the heading direction of the moving body,
wherein a Q factor by the power supply coil current is less than 100 and the Q

factor is determined by $Q_S = \dfrac{w L_S}{R_S}$ ,

where w denotes an angular frequency of the power supply coil current, $L_S$ denotes inductance of the power supply coil, and $R_S$ denotes resistance of the power supply coil.

3. The power supply device of claim 2, wherein a cross-section of the magnetic pole perpendicular to the heading direction of the moving body has a "U" shape, and
the power supply coil is disposed within the U-shaped magnetic pole to be in parallel with the heading direction of the moving body.

4. The power supply device of claim 2, wherein a cross-section of the magnetic pole perpendicular to the heading direction of the moving body has a shape in which two "U"s are horizontally adjacent to each other, and
the power supply coil is disposed to be in parallel with the heading direction of the moving body within each U-shaped magnetic pole.

5. The power supply device of claim 2, wherein the power supply core is provided in a form in which power supply modules, disposed to be in parallel with the heading direction of the moving body and each comprising a plurality of magnetic poles in parallel with each other, are disposed in series.

6. A power supply device for supplying power to a moving body using a magnetic induction method, the power supply device comprising:

   a power supply core comprising at least one magnetic pole disposed in series along a heading direction of the moving body; and
   power supply coils disposed to be in parallel with the heading direction of the moving body based on the left and the right of the magnetic pole and to intersect each other between the magnetic poles and in which a current flows so that neighboring magnetic poles of the power supply core have different polarities,
   wherein a Q factor by the power supply coil current is less than 100 and the Q

factor is determined by $Q_S = \dfrac{w L_S}{R_S}$ ,

where w denotes an angular frequency of the power supply coil current, $L_S$ denotes inductance of the power supply coil, and $R_S$ denotes resistance of the power supply coil.

7. The power supply device of claim 6, wherein a cross-section of the magnetic pole perpendicular to the heading direction of the moving body is provided in a "T" shape, and
the power supply coils are disposed to be in parallel with the heading direction of the moving body on the left and right of each magnetic pole and to intersect each other between the magnetic poles, and
currents towards opposite directions flow in the power supply coils disposed on the left and the right of each magnetic pole.

8. The power supply device of claim 6, further comprising:

   a linear magnetic shielding member disposed in a heading direction of a road.

9. The power supply device of claim 6, wherein the power supply core is provided in a form in which power supply modules, each comprising at least one magnetic pole disposed in series along the heading direction of the moving body, are disposed to constitute a column in series.

**10.** The power supply device of claim 9, wherein each of the power supply modules comprises core connecting members at a front end and a rear end, and
power supply core modules are connected to each other using the core connecting members and disposed to constitute a column in series along a heading direction of a road.

**11.** The power supply device of claim 9, wherein the power supply core are disposed to be separate from each other at predetermined intervals to be capable of accommodating a thermal expansion and a thermal shrinkage.

**12.** The power supply device of claim 9, wherein a fiber reinforced plastic (FRP) is installed in an upper portion or a lower portion of the power supply core.

**13.** The power supply device of claim 6, wherein the power supply core has a width perpendicular to the heading direction of the moving body less than or equal to a half of an interval between centers of the magnetic poles.

**14.** The power supply device of claim 6, wherein a length of the magnetic pole towards the heading direction of the moving body is two folds or more of a distance between an end portion of the magnetic pole and an end portion of a magnetic pole adjacent thereto.

**15.** A power pickup device to be supplied with power from a power supply device disposed along a heading direction of a moving body and installed in the moving body, the power pickup device comprising:

a power pickup core disposed at a lower end of the moving body to be separate from the power supply device by a predetermined interval; and
a power pickup coil disposed in the power pickup core in a loop form to flow an induction current induced from the power supply device,
wherein a Q factor by the power pickup coil current is less than 100 and the Q

factor is determined by $Q_L = \dfrac{w L_L}{R_L}$ ,

where w denotes an angular frequency of the power pickup coil current, $L_L$ denotes inductance of the power pickup coil, and $R_L$ denotes resistance of the power pickup coil.

**16.** The power pickup device of claim 15, wherein the power pickup core is provided in a form of a plate or a lattice.

**17.** The power pickup device of claim 15, further comprising:

a magnetic shielding member provided in a loop shape around the power pickup core.

# FIG. 1

# FIG. 2

Power Lines (1st Coil)

## FIG. 3

Resonant Magnetic Field

321

322

20cm

312 ⊙ ⊗ 312

10

311

## FIG. 4

20

Pickup Coil

421

422

⊙ ⊗

Power Line
(Underground)

411

412

## FIG. 5

510

## FIG. 6

610

**FIG. 7**

FIG. 8

FIG. 9

# FIG. 10

Heading direction of moving body

FIG. 11

Heading direction of moving body

## FIG. 12

1210

1220

1211

1212

1230

1240

1211    1212

# FIG. 13

# FIG. 14

Heading direction of
moving body

EP 2 763 281 A2

FIG. 15

1501

1502

# FIG. 16

| | Qs | |
|---|---|---|
| | 14.24 | 115 |
| Power transfer function | 0.872 | 0.880 |

## FIG. 17

| | Qs | |
|---|---|---|
| | 12.82 | 115 |
| Power transfer function @ 18kHz | 0.858 | 0.870 |
| Power transfer function @ 20kHz | 0.512 | 0.055 |

# FIG. 18

| | $Q_L$ | |
|---|---|---|
| | 12.4 | 115.0 |
| Power transfer function | 0.873 | 0.894 |

## FIG. 19

| | | $Q_L$ | |
| --- | --- | --- | --- |
| | | 11.2 | 115.0 |
| Power transfer function @ 18kHz | | 0.848 | 0.869 |
| Power transfer function @ 20kHz | | 0.094 | 0.003 |